# FASCICULE DE BREVET EUROPEEN

(11) **EP 0 514 818 B1**
(45) Date de publication et mention de la délivrance du brevet: **11.03.1998**
(21) Numéro de dépôt: 92108371.3
(22) Date de dépôt: 18.05.1992
(51) Int. Cl.: H03G 3/00, H03G 1/00

(54) **Dispositif amplificateur programmable**
Programmierbarer Verstärker
Programmable amplifier

(30) Priorité: 24.05.1991 FR 9106276
(43) Date de publication de la demande: 25.11.1992
(73) Titulaire: ALCATEL ALSTHOM COMPAGNIE GENERALE D'ELECTRICITE, 75008 Paris (FR)
(72) Inventeur: Vanhecke, Claude, F-31140 Pechbonnieu (FR)
(74) Mandataire: Smith, Bradford Lee

(56) Documents cités:
- FR-A- 2 251 126
- FR-A- 2 291 642
- FR-A- 2 304 125
- NEUES AUS DER TECHNIK. no. 1, 15 Février 1990, WURZBURG DE page 4; 'Digital arbeitender Lautstärkeregler in einem Mehrstufenverstärker.'
- IBM TECHNICAL DISCLOSURE BULLETIN. vol. 14, no. 9, Février 1972, NEW YORK US pages 2639 - 2640; D. MILLICAN: 'Four-level gain control stage'

## Description

L'invention concerne un amplificateur programmable qui peut, notamment, être réalisé sous la forme d'un circuit intégré de type ASIC ("Application Specific Integrated circuit") analogique pour des applications d'amplification dans le domaine des télécommunications spatiales.

Le dispositif de l'invention a pour objet de permettre une amplification de gain compris entre 2ⁿ et 2ⁿ⁻¹ par pas de 2^{p} avec p < n ; n étant le nombre de bits de la commande de gain.

Dans une réalisation sous la forme d'un ASIC, une solution classique, pour obtenir une amplification telle que définie ci-dessus, consiste à utiliser un amplificateur associé à un atténuateur programmable tel que décrit dans l'article intitulé "Programmable attenuator" de A.A Shakhin et A-Ya. Stul (1979 Plenum publishing corporation). Mais on est alors confronté à différents problèmes spécifiques aux circuits intégrés relatifs à :
- la précision des résistances ;
- la bande passante ;
- les composants de commutation.

En effet dans le domaine des circuits intégrés de type ASIC, on mattrise mal la valeur des résistances. On obtient une précision d'environ ± 25% sur la valeur absolue des résistances, alors que pour des résistances en composants discrets cette précision peut être de 1%. De plus on ne peut utiliser de capacité supérieure à quelques dizaines de picoFarad (pF).

Une autre solution consiste à cascader plusieurs amplificateurs ; le premier amplificateur ayant un fort gain pour obtenir le meilleur rapport signal/bruit. Mais alors la bande passante se trouve fortement réduite.

L'invention a pour objet de réaliser un tel dispositif amplificateur programmable qui présente de très bonnes caractéristiques en ce qui concerne :
- la bande passante ;
- le facteur de bruit ;
- le point de compression ;
- le "matching" (adaptation) entre transistors.

Elle propose, à cet effet, un dispositif amplificateur tel que défini par la revendication 1.

Dans une réalisation avantageuse, le dispositif de l'invention comprend un étage d'entrée qui possède un gain fixe et des étages d'amplification ayant deux valeurs de gain commutables ; un étage adaptateur de sortie ; deux circuits de régulation de courant permettant d'utiliser une loi de variation de courant permettant de réaliser une compensation des variations de gain des différents étages ; le premier circuit n'étant jamais inhibé, et le second étant piloté par la commande Marche/Arrêt.

Avantageusement deux étages d'amplification de structures identiques sont placé au milieu de la chaîne des différents étages d'amplification. L'étage d'entrée comprend deux branches disposées en parallèle entre la tension d'alimentation et la masse ; chaque branche comprenant en série une résistance, un transistor, deux transistors en parallèle recevant un signal délivré par le premier circuit de régulation de courant, deux résistances au milieu desquelles se trouve un point d'entrée.

Chaque étage d'amplification à gain commutable comprend deux branches disposées en parallèle, chaque branche comprenant chacune une résistance, un premier transistor et un second transistor à deux émetteurs ; ces deux branches étant reliées aux deux entrées d'un circuit de commutation au travers de deux résistances ; lui-même étant connecté à la masse au travers d'un troisième transistor qui reçoit un signal du second circuit de régulation de courant fonctionnant comme un générateur de courant continu ; des circuits interfaces d'entrée reliés respectivement à la base de chaque second transistor à deux émetteurs permettant de réaliser une translation de niveau pour cascader les étages entre eux ; un circuit comparateur de tension qui reçoit un signal du premier circuit de régulation de courant permettant de sélectionner le gain de l'étage.

Un tel dispositif permet de répondre aux objectifs en gain, bande passante, facteur de bruit définis plus haut. Le facteur de bruit, notamment, est fortement amélioré pour les faibles gains. On obtient un amplificateur dont on peut faire varier le gain par pas de 1dB le produit Gain Bande passante obtenu étant très bon (60 GHz). On obtient une bonne isolation (60 dB).

Avantageusement, il n'est pas nécessaire d'utiliser une contre-réaction continue qui aurait pour effet de modifier le gain.

L'utilisation d'un tel dispositif sous la forme d'un ASIC permet de réaliser une excellente compensation en température. Car tous les circuits sont réalisés sous une forme symétrique.

De plus, étant donné que les étages sont tous réalisés avec des composants identiques, si ce n'est les résistances, bien que ces étages soient cascadés, on obtient une bonne variation de gains, même si ces gains présentent un certain offset.

Avantageusement, on peut utiliser des assemblages de résistances en arrangements parallèle-série pour obtenir des résistances de valeurs plus précises.

Les caractéristiques et avantages de l'invention ressortiront d'ailleurs de la description qui va suivre, à titre d'exemple non limitatif, en référence aux figures annexées sur lesquelles :
- la figure 1 représente une réalisation du dispositif selon l'invention ;
- les figures 2 et 3 représentent deux réalisations de circuit du dispositif selon l'invention ;
- la figure 4 représente un jeu de courbes de réponse du dispositif selon l'invention.

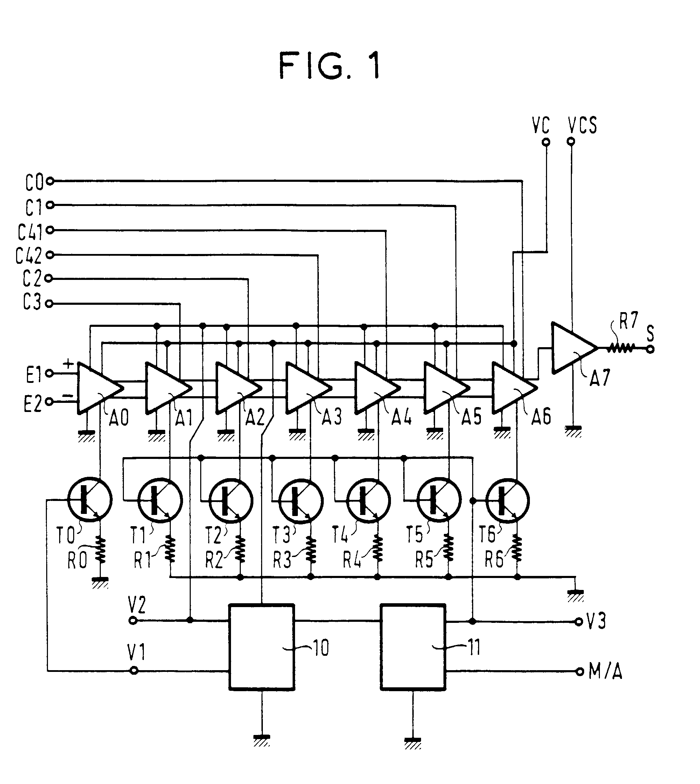

Le dispositif de l'invention, tel que représenté sur la figure 1, comporte plusieurs étages amplificateurs, ici au nombre de 7, Ao, A1, A2, A3, A4, A5, A6 comportant chacun deux entrées et deux sorties permettant un fonctionnement en mode symétrique.

Chacun de ces étages Ao à A6 est alimenté entre une tension Vc et la masse.

Les étages A1 à A6 ont deux valeurs de gain commutables grâce une commande extérieure Ci : ici des bits C3, C2, C42, C41, C1 et Co. Par contre le premier étage Ao possède un gain fixe. Deux étages par exemple A3 et A4 sont identiques en états de gains.

Une sortie de l'étage A6 est reliée à un étage adaptateur de sortie A7 suivi d'une résistance R7, par exemple de valeur 50 OHMS.

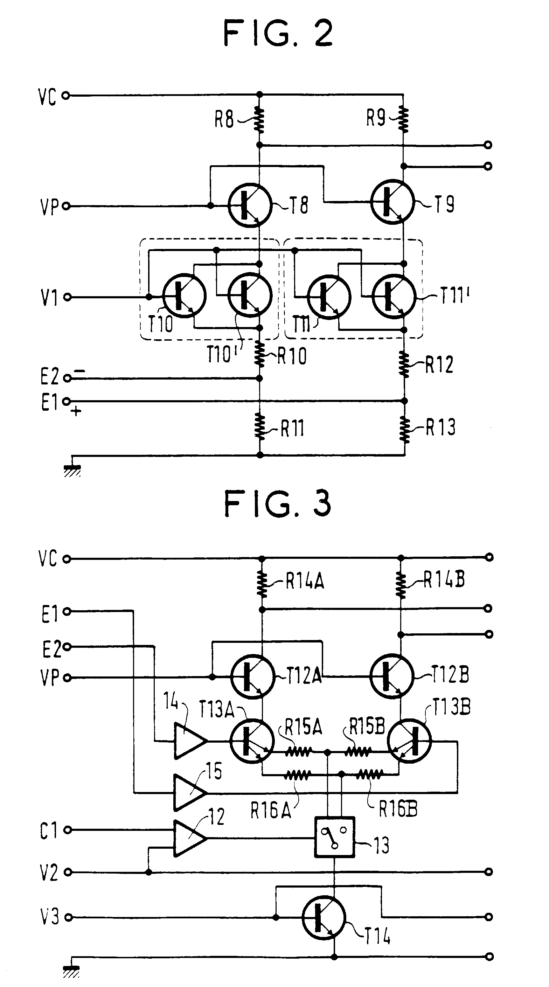

Des transistors To à T6 reliés chacun à la masse au travers d'une résistance Ro à R6 permettent de réaliser une compensation en température de la variation de gain de chacun des étages Ao à A6, en leur délivrant une tension appropriée. Deux circuits de régulation de courant 10 et 11, de type "Bandgap" par exemple, permettent d'utiliser une loi de variation de courant permettant de réaliser cette compensation des variations en température des gains de ces différents étages. Le premier de ces deux circuits peut être appelé "maître" et le second "esclave". Le circuit maître 10 génère un signal V2 servant de tension de référence de l'étage d'entrée Ao et de tensions de seuil pour les circuits comparateurs 12 qui existent dans les étages Al à A6 comme représenté sur la figure 3. Ce circuit 10 n'est jamais inhibé.

Le circuit esclave 11 génère un signal V3 servant de tension de référence des étages A1 à A6, et pilotant les générateurs de courant de ces étages, qui sont les transistors T14 représentés sur la figure 3. Ce circuit peut être inhibé par la commande M/A (Marche/Arrêt). Dans ce cas les étages A1 à A6 ne sont plus alimentés. Ils ne fonctionnent donc plus ; ce qui permet à la fois à isoler les entrées El, E2 de la sortie S. Les impédances d'entrée et de sortie restent, toutefois, maintenues à 50 OHMS, les étages Ao et A7 étant toujours alimentés.

Dans une réalisation avantageuse, ce dispositif est réalisé sous forme d'un ASIC. Les différents étages peuvent, alors, avoir les gains suivants :

| | |
|---|---|
| Ao | 18 dB |
| A1 | 8 dB ou 0 dB |
| A2 | 4 dB ou 0 dB |
| A3 = A4 | 13 dB ou - 3 dB |
| A5 | 2 dB ou 0 dB |
| A6 | 1 dB ou 0 dB. |

Logiquement ces différents étages Ao à A6 auraient dû avoir les gains successifs (32 dB/0 dB) ; (16 dB/0 dB) ; (8 dB/0 dB) ; 4 dB/0 dB) ; (2 dB/0 dB) ; (1 dB/0 dB) ; le plus fort gain étant placé en tête pour obtenir un bon facteur de bruit. Mais une telle structure présente plusieurs inconvénients : le premier est qu'un tel premier étage (32 dB) présenterait une bande passante trop faible (par exemple ; 100 MHz) le second est que dans la position 0 dB de cet étage les conditions de fort gain en entrée de la chaîne ne seraient plus respectées. De plus apparaîtraient des risques d'oscillation HF (possibilité d'atteindre un gain total de 60 dB).

Par contre dans le dispositif de l'invention, tel que représenté sur la figure 1, l'étage Ao a un gain fixe pour améliorer le facteur de bruit de la chaîne complète. Cet étage est optimisé en gain et en fréquence. La valeur de gain de cet étage compense à la fois l'atténuation apportée par les étages A3 et A4 (-6 dB) et par l'étage A6 qui est due au passage du mode symétrique en entrée de celui-ci à un mode asymétrique en entrée de l'étage de sortie A7, et par l'adaptation d'impédance entre cet étage A7 et la charge en sortie, par exemple 50 OHMS.

Les étages de structures identiques A3 et A4 sont placés, ici, au milieu de la chaîne pour réaliser un compromis en ce qui concerne les problèmes de bruit aux différents gains.

Avec les valeurs de gains données plus haut, un tel dispositif permet d'atteindre une valeur de gain maximum de 47 dB en sortie dissymétrique avec 6 bits de commande comme représenté dans le tableau I en fin de description. On peut alors parler de commande "5 bits ½", car, pour obtenir les performances données, le dispositif de l'invention est tel que son gain maximum est supérieur au gain maximum obtenu avec 5 bits de commande extérieure, mais inférieur au gain maximum obtenu avec 6 bits.

Ainsi le dispositif de l'invention a un gain compris entre 2ⁿ et 2ⁿ⁻¹, n étant le nombre de bits de la commande de gain. Chaque étage, y compris l'étage d'entrée, présente un gain maximum inférieur à 2ⁿ⁻¹. Dans l'exemple considéré plus haut, sauf l'étage Ao qui a un rôle particulier, la valeur maximale du gain des étages A1 à A6 est de 13 dB ce qui permet d'obtenir une bande passante de 440 MHz pour l'étage de 13 dB.

Un exemple de réalisation de l'étage d'entrée Ao est représenté sur la figure 2. Cet étage comprend alors deux branches disposées en parallèle entre la tension d'alimentation Vc et la masse ; chaque branche comprenant chacune en série une résistance R8 (R9) un transistor T8 (T9) qui reçoit sur sa base une tension de polarisation continue VP, deux transistors en parallèle T10, T10' (T11, T11'), deux résistances R10 et R11 (R12 et R13).

Cette structure est optimisée pour obtenir la meilleure réponse en fréquence (bande passante), le meilleur facteur de bruit et pour minimiser les effets, dus à l'adaptation nécessaire entre transistors ("Matching"), sur l'offset continu de l'étage.

Les transistors T10 et T11 sont choisis pour leur faible résistance rbb' et leur faible résistance d'accès émetteur RE ; ces valeurs étant d'ailleurs diminuées par le fait de doubler les transistors (Transistors T10 et T10' en parallèle : transistors T11 et T11' en parallèle) ce qui a, de plus, pour effet d'améliorer l'adaptation ("Matching") entre les transistors T10 et T11 par probabilité.

En continu ces transistors T10 (T10') et T11 (T11') servent de générateurs de courant pour les transistors T8 et T9 de manière à obtenir des courants qui varient en température d'une façon adéquate pour maintenir constant le gain de l'étage. Ceci est obtenu en appliquant une tension de "bandgap" de 1,2 volts sur les bases des transistors T10 et T11.

Les transistors T10 (T10') et T11 (T11') sont montés en base commune commandée en tension ; ce qui est optimal pour la réponse en fréquence. La limitation en fréquence vient, en effet, essentiellement :
- de la résistance rbb' (résistance d'accès base);
- des capacités collecteur-substrat Cjs et collecteur-base Cjc. La charge de ces transistors étant la résistance dynamique re des transistors T8 et T9 qui est faible ( par exemple 24 OHMS). Cet effet est donc limité.

Le bruit d'un montage base commune commandé en tension est important parce que les bruits générés par les résistances rbb' et RE et le courant de collecteur IC trouvent un chemin par la source elle-même. Mais les transistors T10 (T10') et T11 (T11') sont suivis des transistors T8 et T9 montés eux aussi en base commune. Les résistances de charges R8 et R9 de ces transistors, de valeurs plus fortes (par exemple 567 OHMS), sont nécessaires pour réaliser le gain de l'étage. Les effets fréquentiels des capacités Cjs et Cjc sont plus importants et nécessitent l'utilisation de transistors plus rapides par exemple de type QN1 dont les caractéristiques sont données sur le tableau II en fin de description. La commande de ces transistors étant cette fois une commande en courant donc une source de forte résistance interne. Les bruits générés par les résistances rbb', RE et le courant collecteur ne trouvent plus de chemin et restent inactifs. Seul le courant de base génére le bruit en sortie.

Enfin les résistances R10 et R12, associées aux résistances d'accès émetteurs RE et dynamiques re des transistors T10 (T10') et T11 (T11'), permettent d'obtenir une impédance d'entrée de 50 OHMS et d'améliorer la linéarité de l'étage d'entrée. Le gain de cet étage, en première approximation, est le rapport entre la résistance de charge R8 (ou R9) et la somme de la résistance R10, (R12) et de (RE+re+(rbb'/BETA)) des transistors T10 et T11. On obtient ainsi une bande passante de 820 MHz environ et un facteur de bruit de 7,9 dB contre respectivement 560 MHz et 11 dB pour un transistor de type QN1 monté en base commune.

Ce circuit, représenté à la figure 2, permet de supprimer les bruits des transistors T8 et T9, en diminuant les capacité parasites collecteur/substrat. On obtient un amplificateur à faible bruit pour un circuit intégré, à fort point de compression (donc à bonne linéarité) et à large bande passante.

Un exemple de réalisation des étages à gain variable A1 à A6 est représenté sur la figure 3. Un tel étage comprend deux branches disposées en parallèle, chaque branche comprenant chacune une résistance R14A (R14B), un transistor T12A (T12B) et un transistor à deux émetteurs T13A (T13B) ; ces deux branches étant reliées aux deux entrées d'un circuit de commutation 13 au travers de deux résistances R15A et R16A (R15B et R16B) ; lui-même étant connecté à la masse au travers d'un transistor T14 fonctionnant comme un générateur de courant continu.

Des circuits interfaces d'entrée 14, 15 permettent de réaliser une translation de niveau pour cascader les étages entre eux. Le circuit 12 est un comparateur de tension qui permet de sélectionner le gain de l'étage. Le transistor T14 permet de réaliser la stabilisation en température du gain de l'étage.

Les transistors T13A et T13B, les résistances R15A, R15B et R16A et R16B permettent d'obtenir deux valeurs de gain différentes sélectionnées par commutation grâce au circuit 13 de l'alimentation en courant :
- avec les composants T13A, T13B, R15A, R15B on obtient une valeur minimun du gain, par exemple ;
- avec les composants T13A, T13B, R16A, R16B on obtient une valeur maximum du gain.

Les transistors T12A et T12B permettent de limiter les effets capacitifs des transistors T13A et T13B (Cjs et Cjc). Ces transistors T12A et T12B ne contribuent pas à augmenter le facteur de bruit de l'étage.

Le gain de l'étage et le rapport entre les résistances de charges R14A et R14B et la somme des résistances R15A, R15B (ou R16A, R16B) et de la somme (RE+re+(rbb'/BETA)) des transistors T13A ou T13B, les fortes valeurs des résistances R15A, R15B et R16A, R16B par rapport aux résistances d'accès émetteurs RE permettent de mieux résoudre les problèmes d'offset continu.

Dans un exemple de réalisation, tel que représenté sur ces trois figures 1, 2 et 3, le dispositif de l'invention a été implanté sous la forme d'un ASIC analogique en utilisant une technologie bipolaire. Les résistances ont été choisies pour obtenir la meilleur précision de gain de chaques étages en fonction du choix limite des techniques d'implantation ("Layout") de type "prédiffusé". Le schéma global comporte 181 transistors, 316 résistances et 1 capacité. Sur l'implantation on a séparé :
- Les masses des étages d'entrée et de sortie pour éviter tout rebouclage à cause de la résistance et de la self des fils de liaison ;
- Les tensions d'alimentation VC et VCS : on a connecté tous les "caissons" des résistances à la tension VC et non à la tension VCS pour éviter un rebouclage des signaux présents sur la ligne VCS vers la masse à cause de la capacité caisson-substrat et des fils de liaison. Ceci entraînerait sinon une oscillation HF pour les fortes valeurs de gain ainsi qu'une mauvaise isolation entrée-sortie en phase de repos.

Malgré les fortes valeurs de gain on n'utilise pas de système de contre réaction continu. D'une part pour conserver de bonnes caractéristiques HF, d'autre part parce que on a introduit des résistances de fortes valeurs dans les émetteurs des transistors ce qui améliore le "Matching". On peut, en effet, remarquer que, aux valeurs de courant utilisé (par exemple 1,2mA), c'est la résistance d'accès émetteur RE qui détermine le "Matching" des transistors. Cette résistance joue également un rôle dans la valeur du gain ; un circuit bon en gain étant bon en offset continu.

Les résistances sont toutes inférieures à 1KILOHM. Elles sont choisies pour optimiser les problèmes de "Matching".

Avantageusement un tel dispositif permet de réaliser une fonction d'amplification dans le domaine VHF avec une programmation du gain de 0 dB à 47 dB par pas de 1 dB. Le facteur de bruit et le point de compression, qui représente un écart de 1 dB vers le bas de la fonction de transfert signal de sortie/signal d'entrée par rapport à une droite de linéarité idéale, sont très bons. Les impédances d'entrée et de sortie sont de 50 OHMS, les entrées de commande sont compatibles TTL et CMOS. Enfin le circuit peut être mis dans une phase de repos avec une isolation entrée-sortie suffisante ; les impédances des accès entrée-sortie gardant leurs valeurs initiales.

La technique de conception retenue est du type "Fullcustom" pour la partie électrique et du type "prédiffusé" pour l'implantation ("Layout").

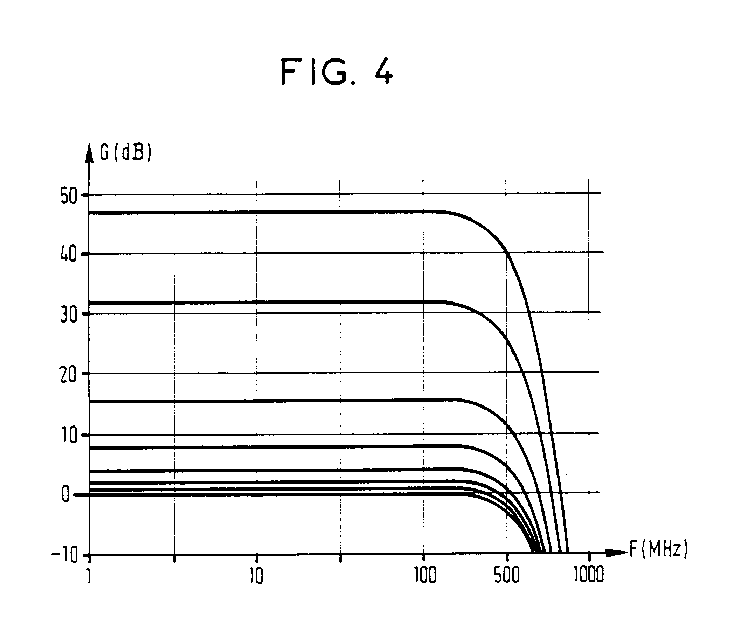

Les résultats obtenus sont regroupés dans le tableau III situé en fin de description et les courbes de réponse gain-fréquence sont représentées à la figure 4.

On remarque que la bande passante reste pratiquement constante quel que soit la valeur du gain. On obtient sur les échantillons du premier essai de configuration ("run") des résultats très satisfaisants à savoir :
- une bande passante de 270 MHz pour un gain maximum de 47 dB soit un produit gain-bande passante de l'ordre de 60 GHz ;
- un facteur de bruit au gain maximum de 10 dB environ ;
- un point de compression de l'ordre de 0 dBM.

Il est bien entendu que la présente invention n'a été décrite et représentée qu'à titre d'exemple préférentiel et que l'on pourra remplacer ses éléments constitutifs par des éléments équivalents sans, pour autant, sortir du cadre de l'invention.

Ainsi, le dispositif de l'invention a été réalisé sous la forme d'un ASIC analogique en utilisant une technologie bipolaire de manière à fonctionner en fréquences VHF. Mais il pourrait être monté en fréquence jusqu'à quelques dizaines de GHz en technologie monolithique de type AsGa.

**TABLEAU I**

| Commandes extérieures | | | | | | Réglage du gain |
|---|---|---|---|---|---|---|
| C0 | C1 | C2 | C3 | C41 | C42 | |
| 0 | 0 | 0 | 0 | 0 | 0 | Référence |
| 1 | 0 | 0 | 0 | 0 | 0 | 1 dB |
| 0 | 1 | 0 | 0 | 0 | 0 | 2 dB |
| 0 | 0 | 1 | 0 | 0 | 0 | 4 dB |
| 0 | 0 | 0 | 1 | 0 | 0 | 8 dB |
| 0 | 0 | 0 | 0 | 1 | 0 | 16 dB |
| 0 | 0 | 0 | 0 | 0 | 1 | 16 dB |
| Autres combinaisons | | | | | | Tous les bits sont sélectionnés |

**TABLEAU II**

| | QN1 | QN2 |
|---|---|---|
| Ft (fréquence de transition) | 2,5 GHz | 2,5 GHz |
| re | 24 ohms | 21 ohms |
| rbb' | 260 ohms | 150 ohms |
| Cjc | 128 fF (1fF = 10⁻¹⁵F) | 205 fF |
| Cjs | 150 fF | 230 fF |

**TABLEAU III**

| Tension d'alimentation | 5 V |
|---|---|
| Bande de fréquences | 0 à 270 MHz |
| Courant continu | 29 mA |
| Précision du gain référence | +/- 2 dB |
| Précision du pas de gain | +/ - 0,3 dB |
| Valeur de bruit à gain maximum | 11 dB |
| Isolation entrée/sortie | < 45 dB |

## Revendications

1. Dispositif amplificateur programmable de gain dont le gain maximal evalué en decibels est compris entre 2ⁿ et 2ⁿ⁻¹ par pas de 2^{p} avec p<n ; n étant le nombre de bits de la commande de gain, ledit dispositif comprennant une pluralité d'étages (A1 à A6) d'amplification à deux valeurs de gain sélectionnées entre elles grâce à un bit de commande, chaque étage ayant un gain maximum inférieur à 2ⁿ⁻¹ ; **caractérisé en ce que** ledit dispositif comprend en outre :
- un premier étage d'entrée (A0) qui possède un gain fixe,
- au moins deux étages de structures identiques (A3,A4) comportant chacun un bit de commande distinct ;
- un étage adaptateur de sortie (A7) ; et
- deux circuits de régulation de courant (10,11) permettant d'utiliser une loi de variation de courant permettant de réaliser une compensation des variations de gain des différents étages ; le premier circuit n'étant jamais inhibé, et le second circuit étant piloté par une commande Marche/Arrêt.

2. Dispositif selon la revendication 1, réalisé sous la forme d'un circuit intégré de type ASIC.

3. Dispositif selon l'une quelconque des revendications précédentes, caracterisé en ce que lesdits au moins deux étages de structures identiques (A3,A4) sont placés au milieu de ladite pluralité d'étages d'amplification.

4. Dispositif selon l'une quelconque des revendications précédentes, caracterisé en ce que ledit étage d'entrée (A0) comprend deux branches disposées en parallèle entre la tension d'alimentation (Vc) et la masse ; chaque branche comprenant en série une résistance (R8 ; R9) un premier transistor (T8 ; T9), deux transitors en parallèle (T10 ; T10' ; T11 ; T11') recevant un signal délivré par le premier circuit de régulation de courant (10), deux résistances (R10 et R11 ; R12 et R13) au milieu desquelles se trouve un point d'entrée (E1 ; E2).

5. Dispositif selon l'une quelconque des revendications précédentes, caracterisé en ce que chaque étage de ladite pluralité d'etages d'amplification à gain commutable (A1 à A6) comprend deux branches disposées en parallèle, chaque branche comprenant une résistance (R14A ; R14B), un premier transistor (T12A ; T12B) et un second transitor à deux émetteurs (T13A ; T13B) ; ces deux branches étant réliées aux deux entrées d'un circuit de commutation (13) au travers de deux résistances (R15A et R16A ; R15B et R16B) ; lui-même étant connecté à la masse au travers d'un troisième transistor (T14) qui reçoit un signal du second circuit de régulation de courant (11) fonctionnant comme un générateur de courant continu ; des circuits interfaces d'entrée (14,15) reliés respectivement à la base de chaque second transistor à deux émetteurs permettant de réaliser une translation de niveau pour cascader les étages entre eux ; un circuit comparateur de tension (12) qui reçoit un signal du premier circuit de régulation de courant (10) permettant de sélectionner le gain de l'étage.

## Patentansprüche

1. Hinsichtlich des Verstärkungsgrads programmierbare Verstärkervorrichtung, deren maximaler Verstärkungsgrad in dB zwischen 2ⁿ und 2ⁿ⁻¹ in Schritten von 2^{p} variabel ist, wobei p < n gilt und n die Anzahl der Bits für die Steuerung des Verstärkungsgrads bedeutet, mit mehreren Verstärkungsstufen (Al bis A6), die zwei mit Hilfe eines Steuerbits auswählbare Werte des Verstärkungsgrads besitzen, wobei jede Stufe einen maximalen Verstärkungsgrad kleiner als 2ⁿ⁻¹ aufweist, dadurch gekennzeichnet, daß die Vorrichtung weiter enthält:
- eine erste Eingangsstufe (A0) mit festem Verstärkungsgrad,
- mindestens zwei Stufen identischer Struktur (A3, A4), die je ein eigenes Steuerbit enthalten,
- eine Ausgangs-Anpassungsstufe (A7),
- und zwei Stromregelschaltungen (10, 11), die die Verwendung eines Stromvariationsgesetzes erlauben, mit dem die Veränderungen des Verstärkungsgrads der verschiedenen Stufen kompensiert werden können, wobei die erste Schaltung niemals außer Betrieb ist, während die zweite durch eine Start/Stop-Steuerung gesteuert wird.

2. Vorrichtung nach Anspruch 1 in Form einer integrierten Schaltung vom Typ ASIC.

3. Vorrichtung nach einem beliebigen der vorhergehenden Ansprüche, dadurch gekennzeichnet, daß die mindestens zwei Stufen identischer Struktur (A3, A4) sich in der Mitte der Mehrzahl von Verstärkungsstufen befinden.

4. Vorrichtung nach einem beliebigen der vorhergehenden Ansprüche, dadurch gekennzeichnet, daß die Eingangsstufe (A0) zwei parallel zwischen der Speisespannung (Vc) und Masse geschaltete Zweige enthält, die je in Reihe einen Widerstand (R8; R9), einen ersten Transistor (T8; T9), zwei parallelgeschaltete Transistoren (T10, T10'; T11, T11'), die ein von der ersten Stromregelschaltung (10) geliefertes Signal empfangen, und zwei Widerstände (R10, R11; R12, R13) enthalten, zwischen denen sich ein Eingangspunkt (E1, E2) befindet.

5. Vorrichtung nach einem beliebigen der vorhergehenden Ansprüche, dadurch gekennzeichnet, daß jede Stufe der Mehrzahl von Verstärkungsstufen mit umschaltbarem Verstärkungsgrad (A1 bis A6) zwei parallele Zweige enthält, die je einen Widerstand (R14A, R14B), einen ersten Transistor (T12A, T12B) und einen zweiten Transistor (T13A, T13B) mit zwei Emittern aufweist, daß diese beiden Zweige an die beiden Eingänge einer Schaltvorrichtung 13) über zwei Widerstände (R15A, R16A; R15B, R16B) angeschlossen sind, die ihrerseits über einen dritten Transistor (T14) an Masse liegen, welcher ein Signal von der als Gleichstromgenerator wirkenden zweiten Stromregelschaltung (11) empfängt, wobei Eingangs-Schnittstellenschaltungen (14, 15), die an die Basiselektrode jedes zweiten Transistors mit zwei Emittern angeschlossen sind, eine Pegelumsetzung bewirken, um die Stufen untereinander in Kaskade zu schalten, und wobei ein Spannungskomparator (12) ein Signal von der ersten Stromregelschaltung (10) empfängt, mit dem der Verstärkungsgrad der Stufe gewählt werden kann.

## Claims

1. Programmable gain amplifier device having a maximum gain expressed in decibels between 2ⁿ and 2ⁿ⁻¹ in steps of 2^{p} where p < n and n is the number of gain control bits, said device comprising a plurality of stages (A1 to A6) having two gain values selectable by a control bit, each stage having a maximum gain less than 2ⁿ⁻¹, **characterised in that** said device further comprises:
- a first input stage (A0) which has a fixed gain,
- at least two identical stages (A3, A4) each having a separate control bit;
- an output matching stage (A7), and
- two current regulator circuits (10, 11) enabling use of a current variation law enabling stage gain variations to be compensated, the first circuit being always enabled and the second circuit being controlled by an On/Off switching signal.

2. Device according to claim 1 implemented as an application specific integrated circuit.

3. Device according to any one of the preceding claims characterised in that said at least two identical amplifier stages (A3, A4) are disposed in the middle of said plurality of amplifier stages.

4. Device according to any one of the preceding claims characterised in that said input stage (A0) comprises two branches in parallel between the supply voltage (VC) and ground, each branch comprising in series a resistor (R8; R9), a first transistor (T8; T9), two transistors in parallel (T10; T10'; T11; T11') receiving a signal delivered by the first current regulator circuit (10) and two resistors (R10 and R11; R12 and R13) a common point of which constitutes an input point (E1; E2).

5. Device according to any one of the preceding claims characterised in that each stage of said plurality of switchable gain amplifier stages (A1 to A6) comprises two branches in parallel each comprising a resistor (R14A; R14B), a first transistor (T12A; T12B) and a twin-emitter second transistor (T13A; T13B), said two branches being connected to two inputs of a switching circuit (13) through two resistors (R15A and R16A; R153 and R16B) and said switching circuit being grounded through a third transistor (T14) which receives a signal from the second current regulator circuit (11) operating as a direct current generator, input interface circuits (14, 15) respectively connected to the base of each twin-emitter second transistor enabling level conversion for cascading the stages and a voltage comparator circuit (12) which receives a signal from the first current regulator circuit (10) enabling the stage gain to be selected.
